# EUROPÄISCHE PATENTANMELDUNG

(11) **EP 3 327 450 A1**
(43) Veröffentlichungstag der Anmeldung: **30.05.2018**
(21) Anmeldenummer: 16200556.5
(22) Anmeldetag: 24.11.2016
(51) Int. Cl.: G01R 31/02

(54) **VORRICHTUNG UND VERFAHREN ZUR UNTERSUCHUNG VON ISOLIERENDEN DRAHTBESCHICHTUNGEN**

(71) Anmelder: Design Composite GmbH, 5722 Niedernsill (AT)
(72) Erfinder: PÖLZLER, Ernst, 8010 Graz (AT)
(74) Vertreter: Sonn & Partner Patentanwälte

(57) **Zusammenfassung**

Vorrichtung (21) und Verfahren zur Untersuchung von isolierenden Drahtbeschichtungen (2) auf einem bewegten elektrisch leitenden Draht (1) mit
- einer Hochspannungserzeugungseinheit (6)
- einer Messelektrode (4)
- einer Erdungselektrode (3), welche den Draht (1) erdet,
- einem Mikroprozessor (8) zur Datenverarbeitung
- sowie einer Messeinheit (31), welche den Messstrom (30), der über die Messelektrode (4) fließt, und/oder die Messspannung (5) zwischen Messelektrode (4) und Erdungselektrode (3) misst und die gemessenen Strom- und/oder Spannungswerte dem Mikroprozessor (8) zur Verfügung stellt, wobei der Mikroprozessor (8) dazu eingerichtet ist, die über die Messeinheit (31) erfassten Strom- und/oder Spannungswerte über zumindest einem kurzen Zeitfenster (17) und zumindest einem langen Zeitfenster (15) zu mitteln, um Anstiege des Messstromes (30) und/oder Einbrüche der Messspannung (5) festzustellen.

## Beschreibung

Die Erfindung betrifft eine Vorrichtung zur Untersuchung von isolierenden Drahtbeschichtungen auf einem bewegten elektrisch leitenden Draht mit einer Hochspannungserzeugungseinheit, einer Messelektrode, einer Erdungselektrode, welche den Draht erdet, einem Mikroprozessor zur Datenverarbeitung sowie einer Messeinheit, welche den Messstrom, der über die Messelektrode fließt, und/oder die Messspannung zwischen Messelektrode und Erdungselektrode misst und die gemessenen Strom- und/oder Spannungswerte dem Mikroprozessor zur Verfügung stellt.

Weiters betrifft die Erfindung ein Verfahren zur Untersuchung von isolierenden Drahtbeschichtungen auf einem elektrisch leitenden Draht mit den Schritten:
- Anbringen einer Erdungselektrode an den Draht;
- Anlegen einer Spannung aus einer Hochspannungserzeugungseinheit an die Drahtbeschichtung;
- Messen des Messstroms, der über die Messelektrode fließt, und/oder der Messspannung zwischen Messelektrode und Erdungselektrode.

Bei beschichteten Drähten, wie sie beispielsweise bei der Produktion von Spulen, Drosseln, Motoren oder Transformatoren benötigt werden, ist es erforderlich, die Isolationseigenschaften der beschichteten Drähte zu gewährleisten, um eine korrekte Funktionsweise und die Sicherheit zu garantieren. Demzufolge werden die Isolationseigenschaften des gerade beschichteten Drahtes bereits am Ende des Beschichtungsverfahrens überprüft. Demnach wird auf einen leitfähigen Draht, z.B. aus Kupfer oder Aluminium, eine Drahtbeschichtung aufgetragen und anschließend deren fehlerfreie Isolation getestet.

Dazu wird zumeist eine Spannung zwischen dem leitfähigen Draht und dem Äußeren der Drahtbeschichtung angelegt, welche im idealisierten fehlerfreien Fall keinen bzw. einen nicht messbaren Strom bewirkt. Ist jedoch zum Beispiel die Drahtbeschichtung an einer Stelle defekt, d.h. nicht oder nur teilweise vorhanden oder in ihrer Homogenität verletzt, so kommt es zu einem messbaren Stromfluss.

Wird nun die Drahtbeschichtung eines Drahtes, der in leitender Verbindung mit der Erdungselektrode steht, in Kontakt mit der Messelektrode gebracht, so kommt es unter idealisierten Bedingungen nur dann zu einem Messstrom, wenn die Isolierung defekt ist. Unter realen Bedingungen fließt trotz der fehlerfreien isolierenden Drahtbeschichtung bereits ein Messstrom, da die Drahtbeschichtung ein Dielektrikum darstellt und daher der Draht und die Drahtbeschichtung ähnlich wie ein Zylinderkondensator wirken. Dieser Messstrom stellt daher einen Ladestrom dar. Wird der Draht nun stetig weiterbewegt, so kommt es zu einem dauerhaften Ladestrom, der den Draht auflädt und die Detektion von Fehlern in der Drahtbeschichtung erschwert, da der Ladestrom auch bei einer fehlerfreien Drahtbeschichtung vorhanden ist. Aufgrund der kapazitiven Eigenschaften der Drahtbeschichtung tritt somit ein Stromfluss auf, der es erheblich erschwert, Fehler in der Drahtbeschichtung korrekt zu detektieren.

Um trotz dieses, von der Intaktheit der Drahtbeschichtung unabhängigen Stromflusses, über die Messung von Stromwerten einen Rückschluss auf die Qualität der Drahtbeschichtung ziehen zu können, wurden im Stand der Technik bereits verschiedene Ansätze vorgeschlagen.

Die EP 2 251 179 A1 offenbart beispielsweise eine Vorrichtung zur Prüfung eines bewegten beschichteten Drahtes, die eine Voraufladungselektrode, eine im Abstand zur Voraufladungselektrode angebrachte Messelektrode und eine Drahterdung aufweist. Die Voraufladungselektrode legt eine Spannung zwischen der Beschichtung und dem leitfähigen Drahtkern an, welche die Beschichtung polarisiert. Während der Draht weiter zur Messelektrode geführt wird, reduziert sich die Polarisation und damit die Spannung an der Beschichtung exponentiell. Durch eine entsprechende Einrichtung weist die Messelektrode eine Spannung, die der Spannung des nunmehr weitergeführten Drahtes entspricht, auf. Dadurch sollen Fehler in der Beschichtung, welche sich durch einen erhöhten Stromfluss über die Messelektrode zeigen, besser erkannt werden.

Eine derartige Strommessung ist allerdings verhältnismäßig aufwendig und kompliziert, da zwei Elektroden angebracht werden müssen, deren Spannung über spezielle Vorrichtungen genau abgestimmt werden müssen, um kapazitive Ausgleichsströme zu minimieren.

Die Aufgabe der vorliegenden Erfindung besteht daher in der Schaffung einer konstruktiv einfachen Vorrichtung bzw. eines vergleichsweise einfachen Verfahrens zur Untersuchung von beschichteten Drähten, die Fehler in der Drahtbeschichtung trotz der störenden kapazitiven Ströme zuverlässig erkennt.

Erfindungsgemäß wird dies bei einer Vorrichtung der eingangs genannten Art dadurch erreicht, dass der Mikroprozessor dazu eingerichtet ist, die über die Messeinheit erfassten Strom-und/oder Spannungswerte über zumindest einem kurzen Zeitfenster und zumindest einem langen Zeitfenster zu mitteln, um Anstiege des Messstromes und/oder Einbrüche der Messspannung festzustellen.

Dazu wird mit Hilfe der Hochspannungserzeugungseinheit im Wesentlichen die Messspannung zur Verfügung gestellt und über die Messelektrode an die Drahtbeschichtung des vorbeigeführten, geerdeten Drahtes gelegt.

Mit Hilfe der Mittelung der Stromwerte in zumindest einem verhältnismäßig langen Zeitfenster, kann der durch die Drahtbewegung fließende (Dauer-)Strom ermittelt werden. Diese Zeitfenster gleiten hierbei vorzugsweise über eine einstellbare Zahl bzw. eine einstellbare Zeitdauer an gemessenen Stromwerten, welche vorzugsweise regelmäßig eingelesen werden, und erstellen so jeweils laufend einen aktuellen Mittelwert für den Messstrom.

Mit Hilfe der Mittelung der Spannungswerte in zumindest einem verhältnismäßig langen Zeitfenster, kann die mittlere Messspannung ermittelt werden. Diese Zeitfenster gleiten vorzugsweise über eine einstellbare Zahl bzw. eine einstellbare Zeitdauer an gemessenen Spannungswerten, welche vorzugsweise regelmäßig eingelesen werden, und erstellen so jeweils laufend einen aktuellen Mittelwert für die Messspannung.

Das zumindest eine lange Zeitfenster für den Messstrom stellt ein Maß für den mittleren Ladesstrom dar, da kurzzeitige Schwankungen des Stromes ausgemittelt werden. Der Ladestrom ist bei gleichbleibenden Bedingungen, wie zum Beispiel der Geometrie des Drahtes und der Drahtbeschichtung, der angelegten Messspannung oder der Geschwindigkeit des vorbeigeführten beschichteten Drahtes etc., im Wesentlichen konstant.

Das zumindest eine kurze Zeitfenster für den Messstrom hingegen zeigt vergleichsweise kurzzeitige Änderungen des Messstromes auf, welche auf Grund von Änderungen in der Drahtbeschichtung entstehen. Dies kann beispielsweise eine Änderung der Dicke oder ein Fehlen der Drahtbeschichtung sein. Für die Messspannung hingegen gilt, dass diese bei einem erhöhten Messstrom, beispielsweise auf Grund von Spannungsabfällen an (Innen-) Widerständen, verringert wird. Das zumindest eine lange Zeitfenster für die Messspannung stellt ein Maß für die mittlere Messspannung dar. Das zumindest eine kurze Zeitfenster stellt ein Maß für kurzfristige Spannungsänderungen dar, welche bei Fehlern in der Drahtbeschichtung auftreten. Somit stehen zwei Größen, Strom und Spannung, zur Auswahl, um Fehler in der Drahtbeschichtung erkennen zu können.

In einer bevorzugten Ausführungsform wird der Mittelwert des zumindest einen langen Zeitfensters vom Mittelwert des zumindest einen kurzen Zeitfenster subtrahiert. Das Ergebnis bei den Zeitfenstern für den Messstrom ist ein Maß für einen Fehlerstrom, der Aufschluss über Fehler in der Drahtbeschichtung gibt. Dieser Fehlerstrom stellt die Abweichung des zumindest einen kurzen Zeitfenster ermittelten, kurzfristigen Mittelwertes vom zumindest einen langen Zeitfenster ermittelten, langfristigen und daher im Wesentlichen vergleichsweise konstanten Mittelwert dar. Diese Abweichung wird von Fehlern in der Dicke der Drahtbeschichtung hervorgerufen, da zusätzlicher oder weniger Ladestrom notwendig ist, ein Spannungsdurchschlag stattfindet bzw. beim gänzlichen Fehlen der Drahtbeschichtung ein Kurzschluss vorhanden ist.

Vorteilhafterweise ist genau ein kurzes und genau ein langes Zeitfenster für den Messstrom und/oder die Messspannung vorgesehen. Die Länge des kurzen Zeitfensters beträgt vorzugsweise zwischen 0.5 ms und 5 ms, insbesondere im Wesentlichen 1 ms. Die Länge des langen Zeitfensters beträgt vorzugsweise zwischen 10 ms und 500 ms, insbesondere im Wesentlichen 100 ms.

Weiters ist es günstig, wenn sich die Längen des genau einen kurzen Zeitfensters und des genau einen langen Zeitfensters zumindest um den Faktor 10, vorzugsweise um den Faktor 100 unterscheiden.

Vorzugsweise weist die Vorrichtung eine Steuer- und/oder Regelungseinheit auf, welche die Messspannung zwischen der Messelektrode und der Erdungselektrode auf einen vorgegebenen Referenzwert regeln bzw. steuern kann. Dazu ist beispielsweise ein PI-Regler vorgesehen, dessen Ausgang die Hochspannungserzeugungseinheit regelt. Der Referenzwert für den PI-Regler kann dabei vom Mikroprozessor vorgegeben werden. Dazu kann der Mikroprozessor einen Digital/Analog-Wandler aufweisen.

Für eine geeignete Regelung ist es günstig, wenn der Steuer- und/oder Regelungseinheit als Rückführungsgröße eine der zwischen Messelektrode und Erdungselektrode anliegenden Messspannung proportionalen Größe zur Verfügung gestellt wird. Dies kann beispielsweise im Wesentlichen dieselbe Spannung sein, die dem Mikroprozessor als Messspannung zur Verfügung gestellt wird. Diese Spannung kann der Mikroprozessor über einen Analog/Digital-Wandler einlesen.

Vorzugsweise kann die Steuer- und/oder Regelungseinheit eine Strombegrenzung aufweisen, welche den Messstrom, der über die Messelektrode fließt, durch Verändern der Messspannung auf einen maximal zulässigen Strom begrenzt. Dazu kann eine weitere Steuerungs- bzw Regelungseinrichtung vorgesehen sein, die Einfluss auf die Hochspannungserzeugungeinheit nimmt. Eine Rückführungsgröße für diese weitere Steuerung- bzw Regeleinheit kann im Wesentlichen derselbe Strom bzw. eine diesem proportionale Spannung sein, der/die dem Mikroprozessor als Messstrom zur Verfügung gestellt wird. Weiters kann zwischen Hochspannungserzeugungseinheit und Messelektrode ein Begrenzungswiderstand vorhanden sein, der bei einem Kurzschluss und fehlerhafter Strombegrenzung den Messstrom begrenzt.

Des Weiteren ist es günstig, wenn die Strombegrenzung einstellbar ist. Beispielsweise kann der maximal zulässige Messstrom vom Mikroprozessor vorgegeben sein.

Die Vorrichtung kann auch eine Geschwindigkeitserfassung des Drahtes aufweisen. Dazu kann zum Beispiel ein Inkrementalgeber oder ein induktiver Initiator von Impulsen vorgesehen sein. Beispielsweise wird der Draht über eine Rolle geführt, deren Drehzahl über Impulse eingelesen und dem Mikroprozessor zur Verfügung gestellt wird. Diese können je nach Verfahren beispielsweise optisch oder induktiv gemessen werden. Demnach kann mit der Kenntnis über die Geometrie der Anordnung die Geschwindigkeit des Drahtes bestimmt werden.

Vorzugsweise kann die Hochspannungserzeugungseinheit zur Umwandlung verschiedener Spannungsniveaus eine Unterspannungsseite niedrigerer Spannung und eine Oberspannungsseite höherer Spannung aufweisen.

Um eine schnelle Messstromerfassung zu gewährleisten, ist es günstig, wenn die Messeinheit den Messstrom und die Messspannung auf der Oberspannungsseite misst, da sich auf Grund von Kapazitäten und etwaigen Filtern der Strom auf der Unterspannungsseite langsamer ändert als der Messstrom auf der Oberspannungsseite.

Um die Messelektrode in Kontakt mit der Drahtbeschichtung zu bringen, kann diese als Messrolle oder als Messbürste, insbesondere aus Kohlefaser, ausgeführt sein. Diese wird dann in schleifenden Kontakt mit der Drahtbeschichtung gebracht. Weiters kann die Messelektrode die Drahtbeschichtung über den gesamten Drahtumfang kontaktieren, indem sie um den Draht herum ausgebildet ist und so gleichmäßig berührt. Dazu ist die Messelektrode mehrteilig versetzt ausgeführt und berührt den Draht von verschiedenen Seiten. Dadurch können Fehler in der Drahtbeschichtung zuverlässig erkannt werden.

Der Messstrom über die Messselektrode kann im Wesentlichen in einem Bereich von 0 bis 200 µA insbesondere mit einer Auflösung von 0.1 µA gemessen werden. Dieser kann mit Hilfe eines Shunt-Widerstandes, an dem der Spannungsabfall zufolge des Messstromes gemessen wird, und entsprechend präzisen Operationsverstärkern ermittelt werden.

Um die Daten, welche der Mikroprozessor ermittelt und verarbeitet, anderen Vorrichtungen zur Verfügung stellen zu können, kann eine Schnittstelle, beispielsweise eine LAN-Schnittstelle, zur Kommunikation mit einer weiteren Vorrichtung, insbesondere Datenverarbeitungsgeräte wie Computer, vorgesehen sein.

Die Hochspannungseinheit kann ein DC/DC Konverter sein um die Gleichspannung auf der Niederspannungsseite, die ein niedrigeres Spannungsniveau aufweist, auf ein höheres Spannungsniveau auf der Oberspannungsseite umwandeln. Der DC/DC Konverter ist dabei vorteilhafterweise variabel einstellbar.

Um Fehler auf Grund von Toleranzen bei der Bauteilfertigung der erfindungsgemäßen Vorrichtung zu minimieren, kann bei dieser Ausführungsform ein Kalibriervorgang für die Messeinheit und der Hochspannungserzeugungseinheit vorgesehen sein. Dieser umfasst folgende Schritte:
Kalibrieren der Hochspannungserzeugungseinheit:
   Dazu wird die Hochspannungserzeugungseinheit auf geeignete Messspannungswerte eingestellt, welche anschließend mit einem externen Hochspannungsvoltmeter gemessen werden. Die Vorgaben des Mikroprozessors werden gemäß den mit dem Hochspannungsvoltmeter gemessenen Werten korrigiert. Zwischen den so ermittelten Messpunkten liegende Spannungswerte können durch lineare Interpolation vorgegeben werden.
Kalibrieren Messeinheit:
   Nach Kalibrierung der Hochspannungserzeugungseinheit wird an geeigneten Punkten eine Messspannung vorgegeben und durch die Messseinheit erfasst. Die dem Mikroprozessor von der Messeinheit zur Verfügung gestellten Messspannungen werden mit dem Hochspannungsvoltmeter verglichen und dementsprechend korrigiert. Nach der durchgeführten Kalibrierung der Messspannung können dazwischen liegende Messspannungen durch lineare Interpolation ermittelt werden.

Anschließend wird die Erfassung des Messstromes korrigiert. Dazu werden zwei geeignete Messströme vorgegeben, beispielsweise durch zwei unterschiedliche Widerstände zwischen der Messelektrode und der Erdungselektrode. Die gemessenen und die vorgegebenen Werte werden verglichen und dementsprechend korrigiert. Dazwischen liegende Messstromwerte können wieder durch lineare Interpolation ermittelt werden.

Das erfindungsgemäße Verfahren der eingangs angeführten Art ist dadurch gekennzeichnet, dass die erfassten Strom- und/oder Spannungswerte über zumindest einem kurzen Zeitfenster und zumindest einem langen Zeitfenster gemittelt werden, um Anstiege des Messstromes und/oder Einbrüche der Messspannung festzustellen. Zwecks Vermeidung von Wiederholungen wird hinsichtlich der erfindungsgemäßen Vorteile des Verfahrens auf vorstehende Ausführungen im Zusammenhang mit der erfindungsgemäßen Vorrichtung verwiesen. Gleiche Vorteile und Effekte ergeben sich bei dem erfindungsgemäßen Verfahren.

Die Erfindung wird nachstehend anhand eines bevorzugten Ausführungsbeispiels, auf welches sie jedoch keinesfalls beschränkt sein soll, im Detail erläutert. Die Figuren zeigen im Einzelnen:
Fig. 1 eine schematische Darstellung eines Drahtes mit Drahtbeschichtung im Querschnitt;
Fig. 2a eine perspektivische Ansicht eines Ausschnitts einer Drahtlackiervorrichtung mit der erfindungsgemäßen Vorrichtung;
Fig.2b eine perspektivische Übersichtdarstellung einer Drahtlackiervorrichtung mit der erfindungsgemäßen Vorrichtung;
Fig. 3 einen Schaltplan einer erfindungsgemäßen Vorrichtung;
Fig. 4a und 4b grafische Darstellungen der gemessenen Stromwerte vor und nach Subtraktion der gemittelten Stromwerte des langen Zeitfensters.

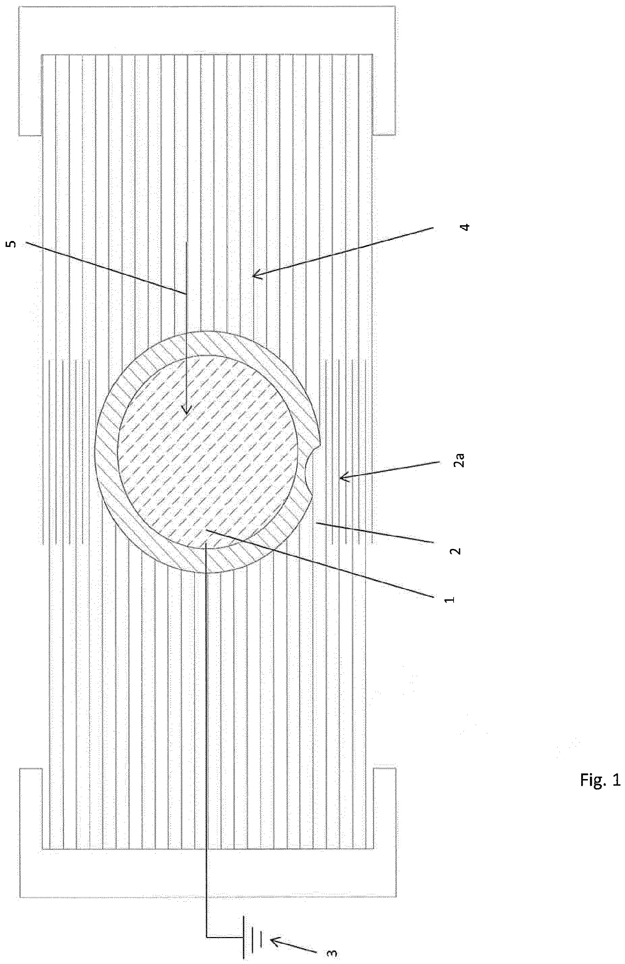

Fig. 1 zeigt eine Prinzipdarstellung eines leitfähigen Drahtes 1 mit einer isolierenden Drahtbeschichtung 2 im Querschnitt.

Der Draht 1, der beispielsweise aus Kupfer oder Aluminium besteht, ist dabei über die Erdungselektrode 3 mit dem gemeinsamen Massepotential 12 der Vorrichtung (nicht gezeigt) verbunden. Des Weiteren steht mit der Drahtbeschichtung 2 eine Messelektrode 4 in Kontakt, die den gesamten Umfang der Drahtbeschichtung umfasst. Diese ist bei diesem Ausführungsbeispiel als Messbürste vorgesehen. Zwischen der Messelektrode 4 und dem geerdeten Draht 1 liegt die Messspannung 5 an. Es tritt daher eine Messspannung zwischen einem gemeinsamen Massepotential der Vorrichtung und der Messelektrode 4 auf, welche im fehlerfreien Fall im Wesentlichen an der isolierenden Drahtbeschichtung abfällt. Die Messelektrode 4 wird in Kontakt mit der Drahtbeschichtung 2 des an der Messelektrode 4 vorbeigeführten Drahtes 1 gebracht. Auf der Unterseite des Drahtes weist die Beschichtung einen Fehler 2a auf.

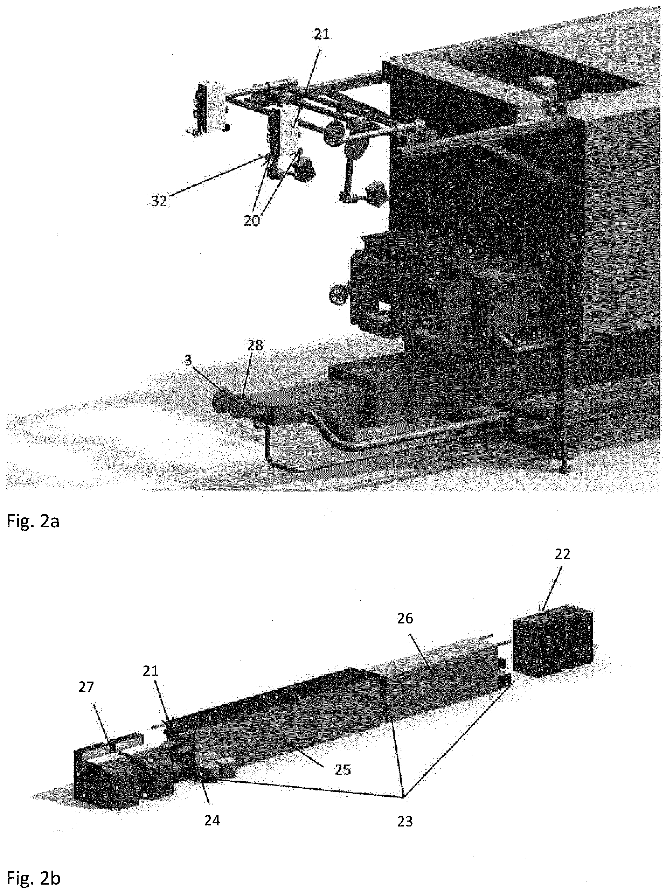

Fig. 2a zeigt eine Drahtlackiervorrichtung mit den erfindungsgemäßen Vorrichtungen 21.

Die Erdungselektrode 3 ist eine leitfähige Bürste, welche beispielsweise aus Kohlefaser gefertigt ist, deren leitfähige Borsten über eine leitfähige Rolle 28 schleifen, mit welcher der noch unbeschichtete Draht 1 weitergeführt wird und somit in leitendem Kontakt mit diesem steht. Andererseits ist die Erdungselektrode 3 wiederum mit dem gemeinsamen Massepotential der Vorrichtung verbunden. Demnach ist der leitfähige unbeschichtete Draht mit dem gemeinsamen Massepotential der Vorrichtung leitend verbunden.

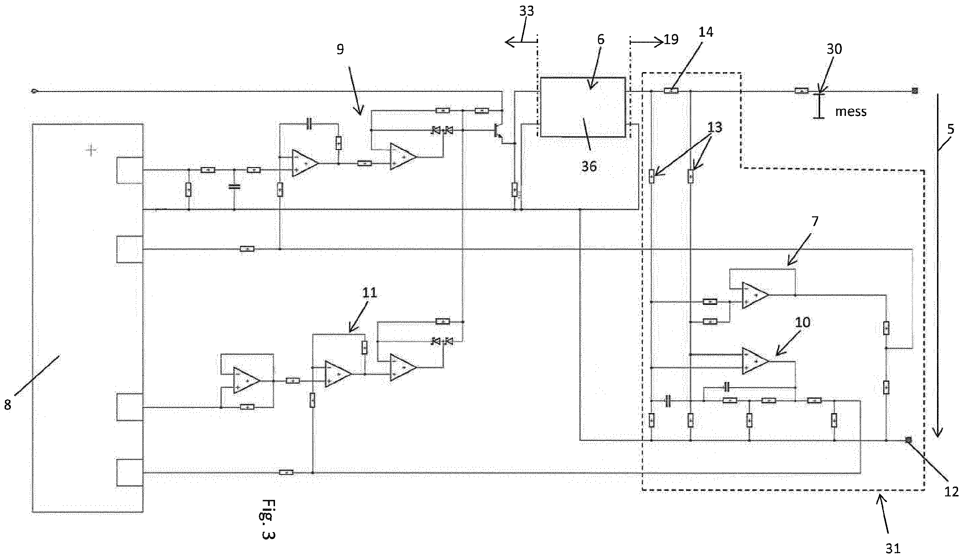

Nachdem der unbeschichtete Draht 1 mit einer Drahtlackiervorrichtung, welche aus dem Stand der Technik bekannt ist, mit einer Drahtbeschichtung 2 versehen wurde, wird dieser mit Hilfe von drahtführenden Rollen 20 zur Messelektrode 4 geführt, welche in dieser Ausführungsform eine Messbürste ist. Die leitfähigen Borsten der Messbürste 4 stehen somit in Kontakt mit der Drahtbeschichtung 2 und verbinden so die Drahtbeschichtung 2 leitfähig mit der Messeinheit 31 (s. Fig. 3). Die Messeinheit 31 kann somit den Messstrom 30 und/oder die zwischen Messbürste 4 und Erdungselektrode 3 auftretende Messspannung und den über die Messbürste 4 fließenden Messstrom 30 ermitteln.

Die Geschwindigkeit des Drahtes kann dabei über eine Geschwindigkeitserfassung 32 mit Hilfe von induktiven Impulsen der drahtführenden Rolle 20 erfasst und eingelesen werden. Die induktiven Impulse können über einen induktiven Sensor erfasst und die Signale dem Mikroprozessor 8 zur Verfügung gestellt werden.

Fig. 2b zeigt die erfindungsgemäße Vorrichtung 21 in einer beispielhaften Anordnung mit den Komponenten einer Drahtlackiervorrichtung. Dazu wird zunächst in einer Ziehmaschine 22 der Draht 1 auf einen gewünschten Durchmesser gebracht und anschließend in eine Glühe 23 geführt, wo das Gefüge des Drahtes 1 rekristallisiert. Der Draht wird danach mit Hilfe eines Lackgeschirrs 24 mit einer Beschichtung 2 versehen, welche in einem Trocknungsofen 25 ausgehärtet wird. Der Draht 1 kann auch mehrmals durch Teile der Drahtlackiervorrichtung geführt werden. Zur Kühlung des Drahtes ist weiters ein Drahtkühler 26 vorgesehen. Zur Untersuchung der Drahtbeschichtung 2 wird der Draht 1 zur erfindungsgemäßen Vorrichtung 21 geführt und anschließend auf Aufwicklern 27 aufgespult.

Fig. 3 zeigt den Schaltplan eines bevorzugten Ausführungsbeispiels mit einer Hochspannungseinheit 6, einer Unterspannungsseite 33 und einer Oberspannungsseite 19. Die Hochspannungserzeugungseinheit ist bei diesem Ausführungsbeispiel ein DC/DC-Konverter 36. Die Spannung an der Oberspannungsseite 19 der Hochspannungserzeugungseinheit 6 entspricht im Wesentlichen der Messspannung 5. Die Messeinheit 31 ist ebenfalls zu sehen.

Weiters zu sehen ist die Spannungsmessung 7, welche die Messspannung über einen Spannungsteiler ermittelt und nach Umwandeln auf ein geeignetes Spannungsniveau einem Mikroprozessor 8 zur Verfügung stellt. Dieser kann Spannungen über Analog/Digitalwandler einlesen.

Weiters ist eine Spannungsregelung 9 vorhanden, welche die Hochspannungseinheit 6 nach den Vorgaben des Mikroprozessors regelt. Die Hochspannungserzeugungseinheit 6 ist vorgesehen um einer (nicht dargestellten) Messelektrode 4 eine Spannung von im Wesentlichen zwischen 300 Volt und 4000 Volt zur Verfügung zu stellen.

Eine Strommessung 10 und eine Strombegrenzung 11 sind ebenfalls vorgesehen, die den maximalen Messstrom regelt. Dazu wird die Spannung an der Oberspannungsseite 19 der Hochspannungserzeugungseinheit 6 bei zu hohem Messstrom 30 soweit verringert, dass der Messstrom 30 einen vom Mikroprozessor vorgegebenen Wert nicht überschreitet. Hierzu umfasst die Strombegrenzung eine Regeleinheit, die ebenfalls die Hochspannungserzeugungseinheit 6 regelt. Als Rückführungsgröße wird im Wesentlichen der Messstrom verwendet.

Ein Massepotential 12 ist sowohl mit der Erdungselektrode 3, als auch mit der Strommessung 10, der Spannungsmessung 7, der Strombegrenzung 11 und dem Mikroprozessor 8 verbunden.

Für die Ermittlung und die anschließende Verarbeitung der Spannungswerte der Messspannung im Mikroprozessor 8 kann die Messspannung mit Hilfe von Spannungsteilern 13 und anderen Hilfsmitteln, wie Operationsverstärkern und deren Beschaltung, auf ein für den Mikroprozessor 8 geeignetes Spannungsniveau herabgesetzt werden. Der Mikroprozessor 8 erfasst die Spannungswerte und diskretisiert diese über einen Analog/Digital-Wandler.

Die Strommessung erfolgt über einen Shunt-Widerstand 14. Die an dem Shunt-Widerstand 14 abfallende Spannung ist dann ein Maß für den Messstrom. Um die am Shunt-Widerstand 14 abfallende Spannung auf ein für den Mikroprozessor geeignetes Spannungsniveau zu bringen, sind wieder Spannungsteiler 13 und Hilfsmittel wie Operationsverstärker und deren Beschaltung vorgesehen.

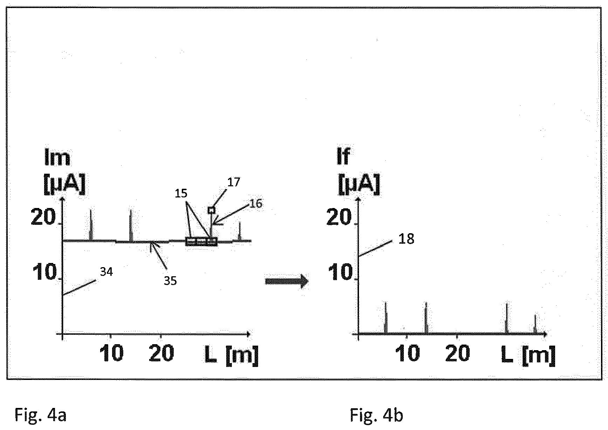

Fig. 4a zeigt eine beispielhafte Anwendung der Vorrichtung an einem an der Messelektrode vorbeigeführten Draht 1,2.

Auf der Abszisse ist die Länge in Meter aufgetragen, wie sie zum Beispiel aus der Geschwindigkeit der Geschwindigkeitserfassung 32 und der vergangenen Zeit berechnet werden kann, auf der Ordinate ist der berechnete (Mittelwert-) Strom 34 in Mikroampere dargestellt. Der berechnete (Mittelwert-) Strom 34 setzt sich aus Überlappungen der Mittelwerte des zumindest einen langen Zeitfensters 15 und des zumindest einen kurzen Zeitfensters 17 zusammen, welche ebenfalls in Meter umgerechnet wurden.

In Fig. 4a ist der Mittelwert 35 des Messstromes 30 dargestellt, wie er durch das zumindest eine lange Zeitfenster 15 ermittelt wird. Die Stromspitze 16 ist ein durch das zumindest eine kurze Zeitfenster 17 ermittelter Mittelwert und kann beispielsweise durch eine defekte Drahtbeschichtung 2 hervorgerufen werden, wie sie in Fig. 1 beim Fehler 2a zu sehen ist. Bei dem bevorzugten Ausführungsbeispiel gibt es genau ein kurzes und ein langes Zeitfenster.

In Fig. 4b ist so dann der Fehlerstrom 18 dargestellt. Der Fehlerstrom 18 wird durch eine Subtraktion des kurzen vom langen Zeitfenster ermittelt, und stelle somit in Maß für die Veränderungen der Drahtbeschichtung 2 dar.

## Patentansprüche

1. Vorrichtung (21) zur Untersuchung von isolierenden Drahtbeschichtungen (2) auf einem bewegten elektrisch leitenden Draht (1) mit
- einer Hochspannungserzeugungseinheit (6)
- einer Messelektrode (4)
- einer Erdungselektrode (3), welche den Draht (1) erdet,
- einem Mikroprozessor (8) zur Datenverarbeitung
- sowie einer Messeinheit (31), welche den Messstrom (30), der über die Messelektrode (4) fließt, und/oder die Messspannung (5) zwischen Messelektrode (4) und Erdungselektrode (3) misst und die gemessenen Strom- und Spannungswerte dem Mikroprozessor (8) zur Verfügung stellt, **dadurch gekennzeichnet, dass** der Mikroprozessor (8) dazu eingerichtet ist, die über die Messeinheit (31) erfassten Strom- und/oder Spannungswerte über zumindest einem kurzen Zeitfenster (17) und zumindest einem langen Zeitfenster (15) zu mitteln, um Anstiege des Messstromes (30) und/oder Einbrüche der Messspannung (5) festzustellen.

2. Vorrichtung nach Anspruch 1, **dadurch gekennzeichnet, dass** die berechneten Mittelwerte (35) der Strom- und/oder Spannungswerte des zumindest einen langen Zeitfenster (15) von den Mittelwerten (16) der Strom- und/oder Spannungswerte des zumindest einen kurzen Zeitfenster (17) subtrahiert werden.

3. Vorrichtung nach Anspruch 2, **dadurch gekennzeichnet, dass** genau ein kurzes Zeitfenster (17), welches vorzugsweise eine Dauer zwischen 0.5 ms und 5 ms, insbesondere im Wesentlichen 1 ms aufweist, und genau ein langes Zeitfenster (15), welches vorzugsweise eine Dauer von 10 ms bis 500 ms, insbesondere im Wesentlichen 100 ms aufweist, vorgesehen ist.

4. Vorrichtung nach Anspruch 3, **dadurch gekennzeichnet, dass** sich die Längen des genau einen kurzen Zeitfensters (17) und des genau einen langen Zeitfensters (15) zumindest um den Faktor 10, vorzugsweise um den Faktor 100 unterscheiden.

5. Vorrichtung nach einem der Ansprüche 1 oder 4, **dadurch gekennzeichnet, dass** die Vorrichtung (21) eine Steuer- und/oder Regelungseinheit (9) aufweist, welche dazu eingerichtet ist, die Messspannung (5) zwischen der Messelektrode (4) und der Erdungselektrode (3) auf einen vorgegebenen Referenzwert zu regeln bzw. zu steuern.

6. Vorrichtung nach Anspruch 5, **dadurch gekennzeichnet, dass** der Steuer- und/oder Regelungseinheit (9) als Rückführungsgröße eine der zwischen Messelektrode und Erdungselektrode anliegenden Messspannung (5) proportionale Größe zur Verfügung gestellt wird.

7. Vorrichtung nach einem der Ansprüche 5 oder 6, **dadurch gekennzeichnet, dass** die Steuer- und/oder Regelungseinheit (9) eine Strombegrenzung (11) aufweist, welche den Messstrom (30), der über die Messelektrode (4) fließt, durch Verändern der Messspannung (5) auf einen maximal zulässigen Strom begrenzt.

8. Vorrichtung nach Anspruch 7, **dadurch gekennzeichnet, dass** der maximale Strom der Strombegrenzung (11) einstellbar ist.

9. Vorrichtung nach einem der Ansprüche Anspruch 1 bis 8, **dadurch gekennzeichnet, dass** die Vorrichtung (21) eine Geschwindigkeitserfassung (32) des Drahtes (1) aufweist.

10. Vorrichtung nach einem der Ansprüche 1 bis 9, **dadurch gekennzeichnet, dass** die Hochspannungserzeugungseinheit (6) zur Umwandlung verschiedener Spannungsniveaus eine Unterspannungsseite (33) niedrigerer Spannung und eine Oberspannungsseite (19) höherer Spannung aufweist und die Messeinheit (31) den Messstrom (30) und/oder die Messspannung (5) auf der Oberspannungsseite (19) misst.

11. Vorrichtung nach einem der Ansprüche 1 bis 10, **dadurch gekennzeichnet, dass** die Messelektrode (4) eine Messrolle oder eine Messbürste, insbesondere aus Kohlefaser, ist und die Drahtbeschichtung (2) über den gesamten Drahtumfang berührt.

12. Vorrichtung nach einem der Ansprüche 1 bis 11, **dadurch gekennzeichnet, dass** der Messstrom (30) über die Messelektrode (4) im Wesentlichen in einem Bereich von 0 bis 200 µA insbesondere mit einer Auflösung von etwa 0.1 µA gemessen wird.

13. Vorrichtung nach einem der Ansprüche 1 bis 12, **dadurch gekennzeichnet, dass** die Vorrichtung (21) zumindest eine Schnittstelle zur Kommunikation mit weiteren Vorrichtungen, insbesondere Datenverarbeitungsgeräten wie Computer, vorgesehen ist.

14. Vorrichtung nach einem der Ansprüche 1 bis 13, dass die Hochspannungserzeugungseinheit (6) ein DC/DC Konverter (36) ist.

15. Verfahren zur Untersuchung von isolierenden Drahtbeschichtungen (2) auf einem elektrisch leitenden Draht (1) mit den Schritten:
- Anbringen einer Erdungselektrode (3) an den Draht (1)
- Anlegen einer Spannung aus einer Hochspannungserzeugungseinheit (6) an die Drahtbeschichtung (2)
- Messen des Messstroms (30) und/oder der Messspannung (5) zwischen Messelektrode (4) und Erdungselektrode (3), der über die Messelektrode (4) fließt, **dadurch gekennzeichnet, dass** die erfassten Strom- und/oder Spannungswerte über zumindest einem kurzen Zeitfenster (17) und zumindest einem langen Zeitfenster (15) gemittelt werden, um Anstiege des Messstromes (30) und/oder Einbrüche der Messspannung (5) festzustellen.
